# EUROPEAN PATENT SPECIFICATION

(11) **EP 4 289 023 B1**
(45) Date of publication and mention of the grant of the patent: **27.08.2025**
(21) Application number: 21930879.8
(22) Date of filing: 19.03.2021
(51) Int. Cl.: H01L 25/075, H01Q 1/00, H01Q 5/20, H10H 20/857, H10H 29/49, H01Q 1/24, H01Q 1/44

(54) **DISPLAY PANEL TRANSPARENT TO ELECTROMAGNETIC SIGNALS**
FÜR ELEKTROMAGNETISCHE SIGNALE DURCHSICHTIGE ANZEIGETAFEL
PANNEAU D'AFFICHAGE TRANSPARENT AUX SIGNAUX ÉLECTROMAGNÉTIQUES

(43) Date of publication of application: 13.12.2023
(73) Proprietor: Huawei Technologies Co., Ltd., Shenzhen, Guangdong 518129 (CN)
(72) Inventor: KAMYSHEV, Timofey, 00180 Helsinki (FI); TIAN, Ruiyuan, 00180 Helsinki (FI); PENG, Weibo, Shenzhen, Guangdong 518129 (CN); YUAN, Lin, Shenzhen, Guangdong 518129 (CN); YANG, Yuchan, Shenzhen, Guangdong 518129 (CN)
(74) Representative: Gill Jennings & Every LLP
(86) International application number: PCT/CN2021/081805
(87) International publication number: WO 2022/193287

(56) References cited:
- EP-A1- 3 041 086
- CN-A- 107 302 128
- CN-A- 107 946 738
- CN-A- 108 933 329
- CN-A- 109 449 548
- CN-A- 110 740 200
- CN-A- 111 129 719
- US-A1- 2010 265 161
- US-A1- 2015 351 292
- US-A1- 2020 144 733
- US-A1- 2020 144 733
- US-A1- 2022 216 599

## Description

### TECHNICAL FIELD

The disclosure relates to a display panel comprising a plurality of light emitting diode clusters, each pair of adjacent light emitting diode clusters being separated by a dielectric gap and interconnected by an interconnection arrangement.

### BACKGROUND

Modern mobile devices such as smartphones need to support more and more radio technology such as cellular technology, e.g. 2G/3G/4G radio, as well as non-cellular technology. In 5G new radio (NR) technology, the frequency range will be expanded from so-called sub-6 GHz frequencies to millimeter-wave frequencies, e.g., between 20 GHz and 70 GHz. At millimeter-wave frequencies, the antenna array of the mobile device will be used to form a beam with higher gain to overcome the higher path loss in the propagation media. However, an antenna radiation pattern and array beam pattern with higher gain will result in a relatively narrow beam width. Beam steering techniques such as phased antenna arrays can be used to steer the beam towards different directions on demand.

The necessary level of omnicoverage is set relatively high for millimeter-wave antennas, such that stable communication can be successfully achieved in all directions and orientations. Conventionally, millimeter-wave antennas are implemented as modules. One or several modules can be assembled onto the main circuit board of the mobile device, the circuit board e.g. comprising an antenna array where the main radiation beam direction is in the broadside direction, i.e., perpendicular to the back cover of the device. The circuit board may also be turned such that the main radiation beam direction is the end-fire direction, i.e., parallel to the display of the device. By utilizing several modules, improved multi-surface spherical beam coverage can be achieved.

However, the integration of several such antenna modules into a mobile device is challenging due to the limited space available within the device. Furthermore, other device components such as conductive frames and displays may prevent omnicoverage.

A typical device comprising an antenna and a display is disclosed in US 2015/0351292 A1.

### SUMMARY

It is an object to provide an improved display panel. The foregoing and other objects are achieved by the features of the independent claims. Further implementation forms are apparent from the dependent claims, the description, and the figures.

According to a first aspect, there is provided a display panel at least partially transparent to electromagnetic signals, the display panel comprising a plurality of light emitting diode clusters, each pair of adjacent light emitting diode clusters being separated by a dielectric gap, and a plurality of first interconnection arrangements configured to interconnect at least two adjacent light emitting diode clusters. The first interconnection arrangements and at least two of the gaps being configured to form at least one two-dimensional slot structure comprising a first section and a second section. The first section is formed by a first gap and having a first length along a first axis, the first length being at least twice as long as a first length of one light emitting diode cluster along the first axis. The second section is formed by a second gap and having a second length along a second axis, the second length being at least twice as long as a second length of the light emitting diode cluster along the second axis. The first interconnection arrangements are configured such that at least one slot structure is transparent to electromagnetic signals in a millimeter-wave frequency band.

Such a display panel allows electromagnetic signals transmitted by an antenna element arranged underneath the display panel to pass through the display panel. Adjacent light emitting diode clusters are separated by a gap, the width of which is small enough that the gap is not visible to the naked eye. The configuration of the first interconnection arrangement allow the gaps to have lengths which are large enough to allow electromagnetic signals, in particular signals within the millimeter-wave frequency band, to pass through the display panel, i.e. radiation towards the front side of a mobile apparatus is achieved. Such through-display front-directional radiation enhances beam coverage and, hence, improves performance and user experience.

In a possible implementation form of the first aspect, the first length of the first section and/or the second length of the second section corresponds to approximately λ/2, λ being a wavelength at a lowest frequency of the electromagnetic signals.

In a possible implementation form of the first aspect, the first length of the first section is approximately 20 times longer than the first length of the light emitting diode cluster when the frequency is 30 GHz, and approximately 10 times longer than the first length of the light emitting diode cluster when the frequency is 60 GHz, and/or the second length of the second section is approximately 20 times longer than the second length of the light emitting diode cluster when the frequency is 30 GHz, and approximately 10 times longer than the second length of the light emitting diode cluster when the frequency is 60 GHz. This allows the display panel to be transparent to electromagnetic signals in a millimeter-wave frequency band without having to add a separate layer to the display panel, a so-called frequency selective surface, allowing the display panel to be as thin as possible, and also reducing the number of redesign steps necessary for providing making a display panel transparent without impairing its functionality.

In a further possible implementation form of the first aspect, the display panel comprises a plurality of first interconnection arrangements repeated periodically along the first axis and the second axis such that the display panel comprises a plurality of periodically repeated slot structures, adjacent slot structures being separated by at least one light emitting diode cluster and at least one gap which is configured to be non-transparent or transparent only to electromagnetic signals outside of the millimeter-wave frequency band. This allows the display panel to be transparent to electromagnetic signals in a millimeter-wave frequency band without affecting the functionality of the display panel, as a display panel, negatively.

In a further possible implementation form of the first aspect, the light emitting diode clusters and first interconnection arrangements are arranged in a conductive layer of the display panel, each light emitting diode cluster comprising a plurality of light emitting elements. This allows conventional light emitting diode clusters to be used while still achieving through-display front-directional radiation.

In a further possible implementation form of the first aspect, the light emitting elements within one light emitting diode cluster are configured to emit light of at least two wavelengths, allowing the display panel to be, e.g., a RGB display panel comprising pixels transmitting visible light in the red, green, and blue wavelength ranges.

In a further possible implementation form of the first aspect, the slot structure has a transmission coefficient that is greater than a predetermined threshold for radio frequency signals at millimeter wave frequencies, allowing such signals to pass through the display panel at each such slot structure.

In a further possible implementation form of the first aspect, the gap has a width of ≤ 10 µm, such that the gap is not visible to the user.

In a further possible implementation form of the first aspect, the plurality of light emitting diode clusters are arranged in a matrix, two adjacent rows of light emitting diode clusters being separated by the first section of the slot structure, two adjacent columns of light emitting diode clusters being separated by the second section of the slot structure, this symmetry allowing use of a dual-polarization antenna module emitting electromagnetic signals in the millimeter-wave frequency band.

In a further possible implementation form of the first aspect, the plurality of light emitting diode clusters are completely aligned along the first axis and along the second axis, facilitating manufacture of the display panel.

In a further possible implementation form of the first aspect, the first section has the same width, i.e. the same dimension in the direction of the second axis, as the first section extends along the first axis, and/or the second section has the same width, i.e. the same dimension in the direction of the first axis, as the second section extends along the second axis, allowing the slot structure to be formed by the aligned gaps between light emitting diode clusters.

In a further possible implementation form of the first aspect, the plurality of light emitting diode clusters are partially misaligned along the first axis and along the second axis, such that at least one light emitting diode cluster of a row of light emitting diode clusters is offset along the first axis, in the direction of the second axis with respect to the other light emitting diode clusters of the row, and/or such that at least one light emitting diode cluster of a column of light emitting diode clusters is offset along the second axis, in the direction of the first axis with respect to the other light emitting diode clusters of the column. This facilitates a display panel which does not need to be planar or rectangular.

In a further possible implementation form of the first aspect, the first section extends non-linearly along the first axis and/or the second section extends non-linearly along the second axis, allowing the configuration of the display panel to be flexible while still being transparent to electromagnetic signals in the millimeter-wave frequency band.

In a further possible implementation form of the first aspect, the plurality of first interconnection arrangements are repeated non-periodically along at least one of the first axis and the second axis such that the display panel comprises a plurality of at least partially non-periodically repeated slot structures, allowing as much as possible of the display panel to be transparent to electromagnetic signals in a millimeter-wave frequency band.

In a further possible implementation form of the first aspect, the first interconnection arrangement is configured to extend directly adjacent the peripheral edges of at least two light emitting diode clusters of a row of light emitting diode clusters or directly adjacent the peripheral edges of at least two light emitting diode clusters of a column of light emitting diode clusters, such that interconnection is achieved without affecting the light emission of the light emitting diode clusters and without affecting the effectiveness of the slot structures.

In a further possible implementation form of the first aspect, the interconnections are made of a non-transparent conducting material with a conductivity which allows the slot structure to have a transmission coefficient that is greater than a predetermined threshold for radio frequency signals at millimeter wave frequencies, allowing the gaps between adjacent light emitting diode clusters to be small enough to be invisible yet the slot structures to be transparent to electromagnetic signals in the millimeter-wave frequency band.

In a further possible implementation form of the first aspect, the first interconnection arrangement comprises interconnections made of an optically transparent conducting material, allowing the interconnections to be invisible to the user.

In a further possible implementation form of the first aspect, the optically transparent conducting material is an optically transparent conducting oxide, preferably indium tin oxide. This material choice does not affect the appearance of the display panel yet provides sufficient sheet-resistance to allow the slot structures to be transparent to electromagnetic signals in the millimeter-wave frequency band.

In a further possible implementation form of the first aspect, the optically transparent conducting material has a conductivity which allows the slot structure to have a transmission coefficient that is greater than a predetermined threshold for radio frequency signals at millimeter wave frequencies, allowing electromagnetic signals in the millimeter-wave frequency band to pass through the slot structure(s) of the display panel in a direction perpendicular to the main plane of the display panel.

In a further possible implementation form of the first aspect, the first interconnection arrangement interconnects adjacent light emitting diode clusters such that one light emitting diode cluster of a row of light emitting diode clusters is interconnected with one or several light emitting diode clusters of the same row of light emitting diode clusters, and/or one light emitting diode cluster of a column of light emitting diode clusters is interconnected with one or several light emitting diode clusters of the same column of light emitting diode clusters. This symmetry allows using a dual-polarization antenna module for the emission of electromagnetic signals in the millimeter-wave frequency band, while still allowing the desired transmission of voltage, current, and certain signals to the light emitting elements.

In a further possible implementation form of the first aspect, the first interconnection arrangement comprises a low-pass filter with a cut-off frequency below a predetermined threshold for radio frequency signals at millimeter wave frequencies or a band-rejection notch filter configured for open circuit rejection of radio frequency signals at millimeter wave frequencies, allowing electromagnetic signals in the millimeter-wave frequency band to pass through the slot structure(s) of the display panel in a direction perpendicular to the main plane of the display panel.

In a further possible implementation form of the first aspect, the display panel further comprises a second interconnection arrangement configured to interconnect adjacent light emitting diode clusters across a dielectric gap not part of the slot structure, the second interconnection providing the dielectric gap with a transmission coefficient that is lower than a predetermined threshold for radio frequency signals at millimeter wave frequencies. This allows a cost-effective use of conventional interconnection arrangements as far as possible, in areas where transparency to electromagnetic signals in the millimeter-wave frequency band is not required.

In a further possible implementation form of the first aspect, the first interconnection arrangement interconnects a set of first adjacent light emitting diode clusters such that one light emitting diode cluster of a row of first light emitting diode clusters is interconnected, across the first section of the slot structure, to one light emitting diode cluster of an adjacent row of first light emitting diode clusters, and/or one light emitting diode cluster of a column of first light emitting diode clusters is interconnected, across the second section of the slot structure, to one light emitting diode cluster of an adjacent column of first light emitting diode clusters, and wherein the second interconnection arrangement interconnects a set of second adjacent light emitting diode clusters, the set of adjacent second light emitting diode clusters being at least partially different from the set of adjacent first light emitting diode clusters, such that one light emitting diode cluster of a row of second light emitting diode clusters is interconnected, across the gap, to one light emitting diode cluster of an adjacent row of second light emitting diode clusters, and/or one light emitting diode cluster of a column of second light emitting diode clusters is interconnected, across the gap, to one light emitting diode cluster of an adjacent column of second light emitting diode clusters. This allows a cost-effective use of conventional interconnection arrangements as far as possible, these conventional interconnections also functioning as end barriers for the slot structures and effectively closing the slot structures such that the slot structures have a limited extent and, hence, provide a certain resonance frequency.

In a further possible implementation form of the first aspect, the light emitting element, the first interconnection arrangement, and/or the second interconnection arrangement is a conductor, allowing transmission of voltage, current, and certain signals to the light emitting elements.

In a further possible implementation form of the first aspect, the slot structure has a shape corresponding to a Greek cross, a cross potent, a rectangle, and a plurality of interconnected rectangles, allowing a variety of slot structure shapes adaptable to the configuration of a specific apparatus.

According to a second aspect, there is provided an electronic apparatus comprising the display panel according to the above, and an antenna module comprising at least one antenna element, the display panel comprising a plurality of stacked layers, a first layer of the display panel comprising the light emitting diode clusters of the display panel, each of the remaining layers of the display panel comprising apertures transparent to electromagnetic signals, at least one of the apertures corresponding to, and being superimposed with, the slot structure(s) formed in the first layer, the slot structure(s) and the apertures being superimposed with the antenna module or the antenna element(s).

By allowing electromagnetic signals, transmitted by an antenna element arranged underneath the display panel of the electronic apparatus, to pass through the display panel, beam coverage is enhanced and, hence, the performance of the apparatus and the user experience are improved.

In a possible implementation form of the second aspect, the first interconnection arrangement(s) is/are arranged in the first layer of the display panel or in a second layer of the display panel adjacent the first layer, allowing the display panel and electronic apparatus to be configured in the most suitable way for that specific apparatus.

In a further possible implementation form of the second aspect, the electronic apparatus comprises a conductive frame forming a peripheral edge of the electronic apparatus, the display panel being arranged in direct physical abutment with the conductive frame, allowing the display panel to be as large as possible, since there is no need for providing a dielectric gap between the conductive frame and the display panel.

In a further possible implementation form of the second aspect, areas of the display panel which are in direct physical abutment with the conductive frame comprise light emitting diode clusters. This allows the active area of the display panel to be substantially the same size as the display panel.

In a further possible implementation form of the second aspect, the slot structures are superimposed with an aperture area of the antenna module or the antenna element, the slot structures together having a total area at least as large as the aperture area, allowing all electromagnetic signals emitted by the antenna module to pass through the display panel.

These and other aspects will be apparent from the embodiment(s) described below.

### BRIEF DESCRIPTION OF THE DRAWINGS

In the following detailed portion of the present disclosure, the aspects, embodiments, and implementations will be explained in more detail with reference to the example embodiments shown in the drawings, in which:
Fig. 1 shows a schematic top view of a display panel comprising interconnected light emitting diode clusters in accordance with prior art;
Fig. 2 shows a schematic top view of a display panel comprising interconnected light emitting diode clusters in accordance with an example of the embodiments of the disclosure;
Fig. 3 shows a schematic top view of a display panel comprising several slot structures in accordance with an example of the embodiments of the disclosure;
Fig. 4 shows a schematic cross-sectional view of a display panel in accordance with an example of the embodiments of the disclosure;
Fig. 5 shows a schematic top view of a display panel comprising interconnected light emitting diode clusters in accordance with an example of the embodiments of the disclosure;
Fig. 6 shows a schematic top view of a slot structure in accordance with an example of the embodiments of the disclosure;
Fig. 7 shows a schematic top view of a display panel comprising interconnected light emitting diode clusters in accordance with an example of the embodiments of the disclosure;
Fig. 8 shows a schematic top view of a display panel comprising interconnected light emitting diode clusters in accordance with an example of the embodiments of the disclosure;
Fig. 9 shows a more detailed partial top view of the embodiment shown in Fig. 8.

### DETAILED DESCRIPTION

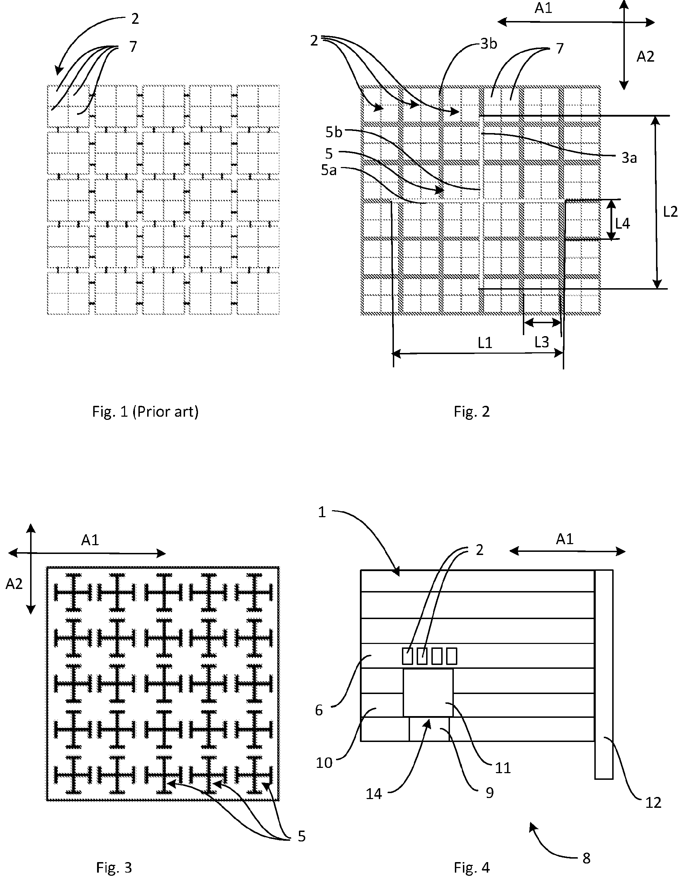

Fig. 4 shows a display panel 1 at least partially transparent to electromagnetic signals, and an electronic apparatus 8 comprising the display panel 1. The electronic apparatus 8 may be any device, such as a smartphone or a tablet, comprising antenna module 9. The antenna module 9 comprises at least one antenna element, such as an array of antenna elements. The antenna module 9 is configured to emit electromagnetic signals in the millimeter-wave frequency band.

The display panel 1 comprises a plurality of stacked layers, a first layer 6 of the display panel 1 comprising at least light emitting diode clusters 2. At least one of the remaining layers of the display panel 1 may comprise apertures **11** which are transparent to the electromagnetic signals emitted by the antenna module 9. The aperture **11** at least corresponds in area to the area of the antenna module 9, preferably the area of the aperture 11 is somewhat larger than the area of the antenna module 9. At least one of the apertures 11 correspond in size to, and are superimposed with, at least one slot structure 5 formed in the first layer 6. For example, the aperture 11 may be a throughgoing opening in a conductive layer, such as a copper sheet layer arranged in the innermost section of the display panel 1. The aperture 11 may also extend through several of the stacked layers of the display panel 1, as long as it does not affect the viewing characteristics of the display panel negatively.

The slot structures 5 are transparent to electromagnetic signals in the millimeter-wave frequency band and described in more detail further below. The slot structures 5 and the apertures 11 are superimposed with the antenna module 9 or the antenna elements, such that electromagnetic signals emitted by the antenna module 9 propagate through the apertures 11 and through the slot structures 5, i.e., through the display panel 1 towards the exterior. The slot structures 5 may together have a total area which is at least as large as an aperture area 14 of the antenna module 9 or the antenna element(s). At least one of the remaining layers of the display panel 1 may comprise slot structures 5 which correspond exactly to the ones present in the first layer 6.

The electronic apparatus 8 comprises a conductive frame 12, indicated in Fig. 4, which forms the peripheral edge of the electronic apparatus 8. The display panel 1 may be arranged in direct physical abutment with the conductive frame 12, i.e., without a notch separating the display panel 1 from the conductive frame 12. Furthermore, some of the above-mentioned light emitting diode clusters 2 may be arranged in areas of the display panel 1 which are in direct physical abutment with the conductive frame 12, allowing the active area of the display panel 1 to extend all the way up to the conductive frame 12.

The display panel 1 is at least partially transparent to electromagnetic signals, the display panel 1 comprising a plurality of light emitting diode clusters 2, each pair of adjacent light emitting diode clusters 2 being separated by a dielectric gap 3a, 3b, and a plurality of first interconnection arrangements 4 configured to interconnect at least two adjacent light emitting diode clusters 2, the first interconnection arrangements 4 and at least two of the gaps 3a being configured to form at least one two-dimensional slot structure 5 comprising a first section 5a and a second section 5b, the first section 5a being formed by a first gap 3a and having a first length L1 along a first axis A1, the first length L1 being at least twice as long as a first length L3 of one light emitting diode cluster 2 along the first axis A1, and the second section 5b being formed by a second gap 3a and having a second length L2 along a second axis A2, the second length L2 being at least twice as long as a second length L4 of the light emitting diode cluster 2 along the second axis A2, the first interconnection arrangements 4 being configured such that at least one slot structure 5 is transparent to electromagnetic signals in a millimeter-wave frequency band.

The first length L3 and the second length L4 of one light emitting diode cluster 2 may be in the 10-µm ranges, e.g., 30 µm x 60 µm. The first length L1 of the first section 5a and the second length L2 of the second section 5b may be 1-2 mm, however, the exact dimensions depend on the dielectric properties of the gaps 3 and other nearby dielectric materials.

As mentioned above, the display panel 1 comprises a plurality of light emitting diode clusters 2, and each pair of adjacent light emitting diode clusters 2 are separated by a dielectric gap 3a, 3b. Each light emitting diode cluster 2 may comprise a plurality of light emitting elements 7, such as pixels, and each light emitting diode cluster 2 may be configured to emit light of at least two wavelengths. The gap may have any suitable width, preferably a width which makes the gap 3a, 3b invisible to the user. The width of the gap 3a, 3b may be ≤ 10 µm. The individual light emitting elements 7 may have dimensions which are in the range of tens of µm.

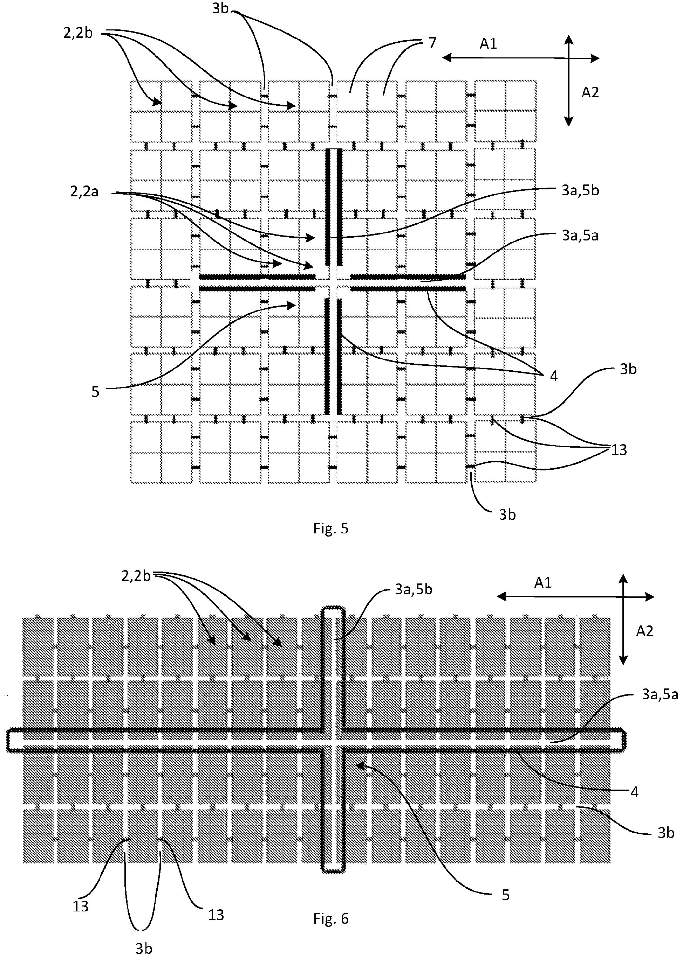

The display panel 1 furthermore comprises a plurality of first interconnection arrangements 4, as shown in Figs. 5, 6, 7, and 9, which are configured to interconnect at least two adjacent light emitting diode clusters 2, providing current, voltage, and certain signals to and between light emitting elements 7. Fig. 1 shows a plurality of interconnected light emitting diode clusters 2 according to prior art.

As shown in Fig. 4, the light emitting diode clusters 2 and the first interconnection arrangements 4 may be arranged in a conductive layer 6 of the display panel 1. The first interconnection arrangements 4 may also be arranged in a second layer of the display panel 1 adjacent the first layer 6 (not shown).

As suggested in Figs. 2, 3, 5 and 6, the first interconnection arrangements 4 and at least two of the gaps 3a are configured to form at least one two-dimensional slot structure 5 comprising a first section 5a and a second section 5b, the first section 5a extending horizontally, and the second section 5b extending vertically, in the referred to Figs. Nevertheless, the extent of the sections 5a, 5b of the slot structure 5 in real life depends on the momentaneous arrangement, in space, of the display panel 1, i.e., on how the user is holding the electronic apparatus 8 comprising the display panel 1. The first section 5a may extend in a direction corresponding to the width of the display panel 1, and the second section 5b may extend in a direction corresponding to the height of the display panel 1. Clearly, the slot structure 5 also extends in a third dimension, in a direction corresponding to the thickness of the display panel 1. However, this third dimension is of no importance for the transparency of the display panel 1 to electromagnetic signals and is therefore not discussed further.

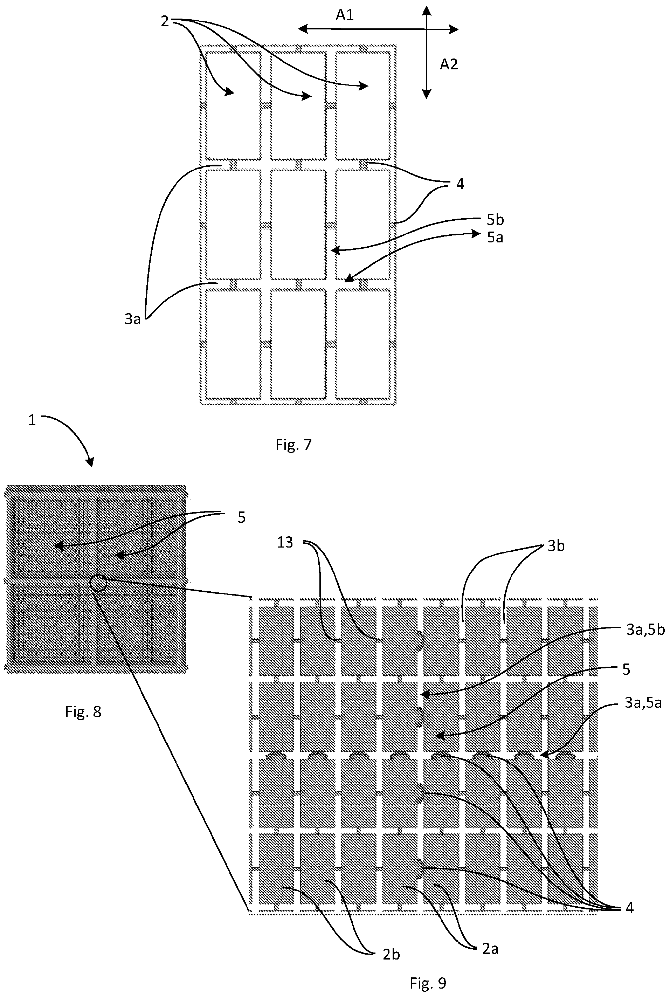

The slot structure 5 may have a shape corresponding to a Greek cross as shown in Figs. 2, 5, 6, and 7, a cross potent as shown in Fig. 3, a rectangle, or a plurality of interconnected rectangles as shown in Fig. 8.

The first section 5a of the slot structure 5 is formed by a first gap 3a and has a first length L1 along a first axis A1, as mentioned above and shown in Fig. 2 The first length L1 is at least twice as long as a first length L3 of one light emitting diode cluster 2 along the first axis A1, the first length L3 corresponding to the width of the light emitting diode cluster 2. Correspondingly, the second section 5b of the slot structure 5 is formed by a second gap 3a and has a second length L2 along a second axis A2. The second length L2 is at least twice as long as a second length L4 of the light emitting diode cluster 2 along the second axis A2, the second length L4 corresponding to the height of the light emitting diode cluster 2. The first length L3 and the second length L4 of the light emitting diode cluster 2 may be identical or non-identical. The first length L3 and the second length L4 may extend perpendicular to each other, or at any suitable angle allowing the light emitting diode cluster 2 to be rectangular or to have any suitable shape. The light emitting diode clusters 2 may comprise identical arrangements of light emitting elements 7, or may be individually different in both type and number of light emitting elements 7.

The first length L1 of the first section 5a and/or the second length L2 of the second section 5b may correspond to approximately λ/2, λ being a wavelength at a lowest frequency of the electromagnetic signals. However, many other parameters may influence the length of the sections, such as e.g. material characteristics. Preferably, the first length L1 of the first section 5a is many times longer than the first length L3 of one light emitting diode cluster 2, and the second length L2 of the second section 5b is many times longer than the second length L4 of one light emitting diode cluster 2. The first length L1 of the first section 5a may be approximately 20 times longer than the first length L3 of the light emitting diode cluster 2 when the frequency of the electromagnetic signals is 30 GHz. The length L1 of the first section 5a may be approximately 10 times longer than the first length L3 of the light emitting diode cluster 2 when the frequency is 60 GHz. Correspondingly, the second length L2 of the second section 5b may be approximately 20 times longer than the second length L4 of the light emitting diode cluster 2 when the frequency of the electromagnetic signals is 30 GHz. The second length L2 of the second section 5b may be approximately 10 times longer than the second length L4 of the light emitting diode cluster 2 when the frequency is 60 GHz.

The first interconnection arrangements 4 are configured such that at least one slot structure 5 is transparent to electromagnetic signals in a millimeter-wave frequency band, i.e., electromagnetic signals within the millimeter-wave frequency can pass through sections of the display panel 1.

A plurality of first interconnection arrangements 4 may be repeated periodically along the first axis A1 and the second axis A2 such that the display panel 1 comprises a plurality of periodically repeated slot structures 5 as shown in Fig. 3. Figs. 7 and 9 show first interconnection arrangements 4 which are repeated periodically along the first axis A1 and the second axis A2. Adjacent slot structures 5 may be separated by at least one light emitting diode cluster 2 and at least one gap 3b which is configured to be either non-transparent to electromagnetic signals or transparent only to electromagnetic signals outside of the millimeter-wave frequency band. The slot structure 5 has, in other words, a transmission coefficient that is greater than a predetermined threshold for radio frequency signals at millimeter wave frequencies.

The plurality of light emitting diode clusters 2 may be arranged in a matrix, two adjacent rows of light emitting diode clusters 2 being separated by the first section 5a of the slot structure 5, and two adjacent columns of light emitting diode clusters 2 being separated by the second section 5b of the slot structure 5. As shown in Figs. 2, 3, and 5 to 9, the plurality of light emitting diode clusters 2 may be completely aligned along the first axis A1 and along the second axis A2. Hence, the first section 5a may maintain the same width, i.e. the same dimension in the direction of the second axis A2, as it extends along the first axis A1, and/or the second section 5b may maintain the same width, i.e. the same dimension in the direction of the first axis A1, as it extends along the second axis A2.

The plurality of light emitting diode clusters 2 may also be partially misaligned along the first axis A1 and along the second axis A2, such that at least one light emitting diode cluster 2 of a row of light emitting diode clusters 2 is offset along the first axis A1, in the direction of the second axis A2 with respect to the other light emitting diode clusters 2 of the row, and/or such that at least one light emitting diode cluster 2 of a column of light emitting diode clusters 2 is offset along the second axis A2, in the direction of the first axis A1 with respect to the other light emitting diode clusters 2 of the column (not shown). The first section 5a may extend non-linearly along the first axis A1 and/or the second section 5b extend non-linearly along the second axis A2 (not shown).

The plurality of first interconnection arrangements 4 may be repeated non-periodically along at least one of the first axis A1 and the second axis A2 such that the display panel 1 comprises a plurality of at least partially non-periodically repeated slot structures 5. Fig. 5 shows a repetition of first interconnection arrangements 4 which is non-periodical along the first axis A1 and the second axis A2. Nevertheless, the complete slot structures 5 may still be repeated periodically.

As shown in Fig. 5, the first interconnection arrangement 4 may be configured to extend directly adjacent the peripheral edges of at least two light emitting diode clusters 2 of a row of light emitting diode clusters 2 or directly adjacent the peripheral edges of at least two light emitting diode clusters 2 of a column of light emitting diode clusters 2.The first interconnection arrangement 4 may extend in parallel with the peripheral edges, in a wave form or follow any path as long as it does not traverse the gap 3a, i.e. extend from one light emitting diode cluster 2 to an adjacent light emitting diode cluster 2.

The first interconnection arrangements 4 used to form one slot structure 5 preferably extend in opposite directions along the first axis A1 and the second axis A2, such that the first section 5a is formed substantially between a pair of first interconnection arrangements 4 extending along the first axis A1, and the second section 5b is formed substantially between a pair of first interconnection arrangements 4 extending along the second axis A2.

The first interconnection arrangement 4 may interconnect adjacent light emitting diode clusters 2 such that one light emitting diode cluster 2 of a row of light emitting diode clusters 2 is interconnected with one or several light emitting diode clusters 2 of the same row of light emitting diode clusters 2, Correspondingly, one light emitting diode cluster 2 of a column of light emitting diode clusters 2 may be interconnected to one or several light emitting diode clusters 2 of the same column of light emitting diode clusters 2.

As shown in Fig. 7, the interconnections may be made of a conducting material with a conductivity which allows the slot structure 5 to have a transmission coefficient that is greater than a predetermined threshold for radio frequency signals at millimeter wave frequencies. The transmission coefficient relates to radio frequency signals at millimeter wave frequencies which propagate from below the display panel 1 to above the display panel 1, i.e. along an axis perpendicular to the first axis A1 as well as the second axis A2.

Radio frequency signals at millimeter wave frequencies which propagate along the first axis A1, the second axis A2, or in the plane formed by the first axis A1 and the second axis A2, e.g. emitted by a neighboring light emitting diode cluster 2, will not be able to propagate through the slot structure 5.

The conducting material may be optically transparent or non-transparent. The optically transparent conducting material may be an optically transparent conducting oxide, preferably indium tin oxide. A conducting material with lower conductivity can exhibit high sheet resistance, electromagnetic signals to pass by through the gap 3a. The suitable sheet-resistance is based in part on area of the interconnection. For example, for an interconnection extending across a gap 3 of 5 µm, a sheet-resistance of 500 Ω/sq or more is preferred to keep the gap 3 open and allow mmWave frequencies to pass through the slot structure 5 of the display panel 1.

As suggested in Figs. 8 and 9, the first interconnection arrangement 4 may comprise a low-pass filter with a cut-off frequency below a predetermined threshold for radio frequency signals at millimeter wave frequencies. A basic assumption for a low-pass filter may be an inductor lumped element. With the low-pass filter, the light-emitting elements 7 are inter-connected for direct current and low-frequency signals, whereas for mmWave frequencies, the gap remains open and thus allowing the slot structure 5 to be formed. For example, an equivalent low-pass filter of 20 nH inductance would be sufficient to achieve a pass-band in the display panel 1 for mmWave frequencies from 20 GHz to 60 GHz.

The first interconnection arrangement 4 may also comprise a band-rejection notch filter configured for open circuit rejection of radio frequency signals at millimeter wave frequencies.

The display panel 1 may further comprise a second interconnection arrangement 13 configured to interconnect adjacent light emitting diode clusters 2 across a dielectric gap 3b which is not part of the slot structure 5. In other words, the second interconnection 13 provides the dielectric gap 3b with a transmission coefficient that is lower than a predetermined threshold for radio frequency signals at millimeter wave frequencies, as opposed to first interconnections 4 which provide dielectric gaps 3a with a transmission coefficient that is higher than the predetermined threshold for radio frequency signals at millimeter wave frequencies. The second interconnection 13 may comprise any conventional, suitable interconnection configured to transmit current, voltage and certain signals.

As shown in Figs. 5, 6, and 9, second interconnection arrangements 13 may interconnect a set of second adjacent light emitting diode clusters 2b, the set of adjacent second light emitting diode clusters 2b being at least partially different from the set of adjacent first light emitting diode clusters 2a, such that one light emitting diode cluster 2 of a row of second light emitting diode clusters 2 is interconnected, across the gap, to one light emitting diode cluster 2 of an adjacent row of second light emitting diode clusters 2, and/or one light emitting diode cluster 2 of a column of second light emitting diode clusters 2 is interconnected, across the gap, to one light emitting diode cluster 2 of an adjacent column of second light emitting diode clusters 2.

The light emitting element 7, the first interconnection arrangement 4, and/or the second interconnection arrangement 13 may be a conductor.

The various aspects and implementations have been described in conjunction with various embodiments herein. However, other variations to the disclosed embodiments can be understood and effected by those skilled in the art in practicing the claimed subject-matter, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

The reference signs used in the claims shall not be construed as limiting the scope. Unless otherwise indicated, the drawings are intended to be read (e.g., cross-hatching, arrangement of parts, proportion, degree, etc.) together with the specification, and are to be considered a portion of the entire written description of this disclosure. As used in the description, the terms "horizontal", "vertical", "left", "right", "up" and "down", as well as adjectival and adverbial derivatives thereof (e.g., "horizontally", "rightwardly", "upwardly", etc.), simply refer to the orientation of the illustrated structure as the particular drawing figure faces the reader. Similarly, the terms "inwardly" and "outwardly" generally refer to the orientation of a surface relative to its axis of elongation, or axis of rotation, as appropriate.

The invention is defined by the appended claims.

## Claims

1. A display panel (1) at least partially transparent to electromagnetic signals, said display panel (1) comprising
- a plurality of light emitting diode clusters (2), each pair of adjacent light emitting diode clusters (2) being separated by a dielectric gap (3a, 3b), and
- a plurality of first interconnection arrangements (4) configured to interconnect at least two adjacent light emitting diode clusters (2),
said first interconnection arrangements (4) and at least two of said gaps (3a) being configured to form at least one two-dimensional slot structure (5) comprising a first section (5a) and a second section (5b),
said first section (5a) being formed by a first gap (3a) and having a first length (L1) along a first axis (A1), said first length (L1) being at least twice as long as a first length (L3) of one light emitting diode cluster (2) along said first axis (A1), and said second section (5b) being formed by a second gap (3a) and having a second length (L2) along a second axis (A2), said second length (L2) being at least twice as long as a second length (L4) of said light emitting diode cluster (2) along said second axis (A2),
said first interconnection arrangements (4) being configured such that at least one slot structure (5) is transparent to electromagnetic signals in a millimeter-wave frequency band.

2. The display panel (1) according to claim 1, comprising a plurality of first interconnection arrangements (4) repeated periodically along said first axis (A1) and said second axis (A2) such that said display panel (1) comprises a plurality of periodically repeated slot structures (5), adjacent slot structures (5) being separated by at least one light emitting diode cluster (2) and at least one gap (3b) which is configured to be non-transparent or transparent only to electromagnetic signals outside of the millimeter-wave frequency band.

3. The display panel (1) according to claim 1 or 2, wherein said light emitting diode clusters (2) and first interconnection arrangements (4) are arranged in a conductive layer (6) of said display panel (1), each light emitting diode cluster (2) comprising a plurality of light emitting elements (7).

4. The display panel (1) according to any one of the previous claims, wherein said slot structure (5) has a transmission coefficient that is greater than a predetermined threshold for radio frequency signals at millimeter wave frequencies.

5. The display panel (1) according to any one of the previous claims, wherein said plurality of light emitting diode clusters (2) are arranged in a matrix, two adjacent rows of light emitting diode clusters (2) being separated by said first section (5a) of said slot structure (5), two adjacent columns of light emitting diode clusters (2) being separated by said second section (5b) of said slot structure (5).

6. The display panel (1) according to claim 5, wherein said plurality of light emitting diode clusters (2) are completely aligned along said first axis (A1) and along said second axis (A2).

7. The display panel (1) according to claim 5 or 6, wherein said plurality of light emitting diode clusters (2) are partially misaligned along said first axis (A1) and along said second axis (A2), such that at least one light emitting diode cluster (2) of a row of light emitting diode clusters (2) is offset along said first axis (A1), in the direction of said second axis (A2) with respect to the other light emitting diode clusters (2) of said row, and/or such that at least one light emitting diode cluster (2) of a column of light emitting diode clusters (2) is offset along said second axis (A2), in the direction of said first axis (A1) with respect to the other light emitting diode clusters (2) of said column.

8. The display panel (1) according to claim 5, wherein said first interconnection arrangement (4) is configured to extend directly adjacent the peripheral edges of at least two light emitting diode clusters (2) of a row of light emitting diode clusters (2) or directly adjacent the peripheral edges of at least two light emitting diode clusters (2) of a column of light emitting diode clusters (2).

9. The display panel (1) according to any one of claims 1 to 5, wherein said first interconnection arrangement (4) comprises interconnections made of an optically transparent conducting material.

10. The display panel (1) according to claim 9, wherein said optically transparent conducting material has a conductivity which allows said slot structure (5) to have a transmission coefficient that is greater than a predetermined threshold for radio frequency signals at millimeter wave frequencies.

11. The display panel (1) according to claim 9 or 10, wherein said first interconnection arrangement (4) interconnects adjacent light emitting diode clusters (2) such that one light emitting diode cluster (2) of a row of light emitting diode clusters (2) is interconnected, across said first section (5a) of said slot structure (5), to one light emitting diode cluster (2) of an adjacent row of light emitting diode clusters (2), and/or
one light emitting diode cluster (2) of a column of light emitting diode clusters (2) is interconnected, across said second section (5b) of said slot structure (5), to one light emitting diode cluster (2) of an adjacent column of light emitting diode clusters (2).

12. The display panel (1) according to any one of claims 1 to 7, wherein said first interconnection arrangement (4) comprises a low-pass filter with a cut-off frequency below a predetermined threshold for radio frequency signals at millimeter wave frequencies or a band-rejection notch filter configured for open circuit rejection of radio frequency signals at millimeter wave frequencies.

13. The display panel (1) according to any one of the previous claims, further comprising a second interconnection arrangement (13) configured to interconnect adjacent light emitting diode clusters (2) across a dielectric gap (3b) not part of said slot structure (5),
said second interconnection (13) providing said dielectric gap (3b) with a transmission coefficient that is lower than a predetermined threshold for radio frequency signals at millimeter wave frequencies.

14. The display panel (1) according to any one of the previous claims, wherein said slot structure (5) has a shape corresponding to a Greek cross, a cross potent, a rectangle, and a plurality of interconnected rectangles.

15. An electronic apparatus (8) comprising the display panel (1) according to any one of claims 1 to 14, and an antenna module (9) comprising at least one antenna element,
said display panel (1) comprising a plurality of stacked layers,
a first layer (6) of said display panel (1) comprising the light emitting diode clusters (2) of said display panel (1), at least one of the remaining layers of said display panel (1) comprising apertures (11) transparent to electromagnetic signals, at least one of said apertures corresponding to, and being superimposed with, the slot structure(s) (5) formed in said first layer (6), said slot structure(s) (5) and said apertures (11) being superimposed with said antenna module (9) or said antenna element(s).

## Patentansprüche

1. Anzeigetafel (1), die mindestens teilweise für elektromagnetische Signale durchsichtig ist, wobei die Anzeigetafel (1) Folgendes umfasst:
- eine Vielzahl von Leuchtdiodenclustern (2), wobei jedes Paar benachbarter Leuchtdiodencluster (2) durch eine dielektrische Lücke (3a, 3b) getrennt ist, und
- eine Vielzahl erster Verbindungsanordnungen (4), die dazu konfiguriert ist, mindestens zwei benachbarte Leuchtdiodencluster (2) miteinander zu verbinden,
wobei die ersten Verbindungsanordnungen (4) und mindestens zwei der Lücken (3a) dazu konfiguriert sind, mindestens eine zweidimensionale Schlitzstruktur (5) zu bilden, umfassend einen ersten Abschnitt (5a) und einen zweiten Abschnitt (5b),
wobei der erste Abschnitt (5a) durch eine erste Lücke (3a) gebildet ist und eine erste Länge (L1) entlang einer ersten Achse (A1) aufweist, wobei die erste Länge (L1) mindestens doppelt so lang wie eine erste Länge (L3) eines Leuchtdiodenclusters (2) entlang der ersten Achse (A1) ist, und der zweite Abschnitt (5b) durch eine zweite Lücke (3a) gebildet ist und eine zweite Länge (L2) entlang einer zweiten Achse (A2) aufweist, wobei die zweite Länge (L2) mindestens doppelt so lang wie eine zweite Länge (L4) des Leuchtdiodenclusters (2) entlang der zweiten Achse (A2) ist,
wobei die ersten Verbindungsanordnungen (4) derart konfiguriert sind, dass mindestens eine Schlitzstruktur (5) für elektromagnetische Signale in einem Millimeterwellenfrequenzband durchsichtig ist.

2. Anzeigetafel (1) nach Anspruch 1, umfassend eine Vielzahl erster Verbindungsanordnungen (4), die sich entlang der ersten Achse (A1) und der zweiten Achse (A2) derart periodisch wiederholt, dass die Anzeigetafel (1) eine Vielzahl sich periodisch wiederholender Schlitzstrukturen (5) umfasst, wobei benachbarte Schlitzstrukturen (5) durch mindestens einen Leuchtdiodencluster (2) und mindestens eine Lücke (3b), die dazu konfiguriert ist, nicht durchsichtig oder nur für elektromagnetische Signale außerhalb des Millimeterwellenfrequenzbands durchsichtig zu sein, getrennt ist.

3. Anzeigetafel (1) nach Anspruch 1 oder 2, wobei die Leuchtdiodencluster (2) und die ersten Verbindungsanordnungen (4) in einer leitfähigen Schicht (6) der Anzeigetafel (1) angeordnet sind, wobei jeder Leuchtdiodencluster (2) eine Vielzahl von Leuchtelementen (7) umfasst.

4. Anzeigetafel (1) nach einem der vorhergehenden Ansprüche, wobei die Schlitzstruktur (5) einen Übertragungskoeffizienten aufweist, der größer als ein vorgegebener Schwellenwert für Hochfrequenzsignale bei Millimeterwellenfrequenzen ist.

5. Anzeigetafel (1) nach einem der vorhergehenden Ansprüche, wobei die Vielzahl von Leuchtdiodenclustern (2) in einer Matrix angeordnet ist, wobei zwei benachbarte Reihen von Leuchtdiodenclustern (2) durch den ersten Abschnitt (5a) der Schlitzstruktur (5) getrennt sind, wobei zwei benachbarte Spalten von Leuchtdiodenclustern (2) durch den zweiten Abschnitt (5b) der Schlitzstruktur (5) getrennt sind.

6. Anzeigetafel (1) nach Anspruch 5, wobei die Vielzahl von Leuchtdiodenclustern (2) entlang der ersten Achse (A1) und entlang der zweiten Achse (A2) vollständig ausgerichtet ist.

7. Anzeigetafel (1) nach Anspruch 5 oder 6, wobei die Vielzahl von Leuchtdiodenclustern (2) entlang der ersten Achse (A1) und entlang der zweiten Achse (A2) derart teilweise fehlausgerichtet ist, dass mindestens ein Leuchtdiodencluster (2) einer Reihe von Leuchtdiodenclustern (2) entlang der ersten Achse (A1) in Richtung der zweiten Achse (A2) in Bezug auf die anderen Leuchtdiodencluster (2) der Reihe versetzt ist, und/oder derart teilweise fehlausgerichtet ist, dass mindestens ein Leuchtdiodencluster (2) einer Spalte von Leuchtdiodenclustern (2) entlang der zweiten Achse (A2) in Richtung der ersten Achse (A1) in Bezug auf die anderen Leuchtdiodencluster (2) der Spalte versetzt ist.

8. Anzeigetafel (1) nach Anspruch 5, wobei die erste Verbindungsanordnung (4) dazu konfiguriert ist, sich unmittelbar benachbart zu den Umfangskanten mindestens zweier Leuchtdiodencluster (2) einer Reihe von Leuchtdiodenclustern (2) oder unmittelbar benachbart zu den Umfangskanten mindestens zweier Leuchtdiodencluster (2) einer Spalte von Leuchtdiodenclustern (2) zu erstrecken.

9. Anzeigetafel (1) nach einem der Ansprüche 1 bis 5, wobei die erste Verbindungsanordnung (4) Verbindungen umfasst, die aus einem optisch durchsichtigen leitfähigen Material hergestellt sind.

10. Anzeigetafel (1) nach Anspruch 9, wobei das optisch durchsichtige leitfähige Material eine Leitfähigkeit aufweist, die es der Schlitzstruktur (5) ermöglicht, einen Übertragungskoeffizienten aufzuweisen, der größer als ein vorgegebener Schwellenwert für Hochfrequenzsignale bei Millimeterwellenfrequenzen ist.

11. Anzeigetafel (1) nach Anspruch 9 oder 10, wobei die erste Verbindungsanordnung (4) benachbarte Leuchtdiodencluster (2) derart verbindet, dass ein Leuchtdiodencluster (2) einer Reihe von Leuchtdiodenclustern (2) über den ersten Abschnitt (5a) der Schlitzstruktur (5) hinweg mit einem Leuchtdiodencluster (2) einer benachbarten Reihe von Leuchtdiodenclustern (2) verbunden ist, und/oder
ein Leuchtdiodencluster (2) einer Spalte von Leuchtdiodenclustern (2) über den zweiten Abschnitt (5b) der Schlitzstruktur (5) hinweg mit einem Leuchtdiodencluster (2) einer benachbarten Spalte von Leuchtdiodenclustern (2) verbunden ist.

12. Anzeigetafel (1) nach einem der Ansprüche 1 bis 7, wobei die erste Verbindungsanordnung (4) einen Tiefpassfilter mit einer Grenzfrequenz unter einem vorgegebenen Schwellenwert für Hochfrequenzsignale bei Millimeterwellenfrequenzen oder einen Bandunterdrückungssperrfilter umfasst, der für Leerlaufunterdrückung von Hochfrequenzsignalen bei Millimeterwellenfrequenzen konfiguriert ist.

13. Anzeigetafel (1) nach einem der vorhergehenden Ansprüche, ferner umfassend eine zweite Verbindungsanordnung (13), die dazu konfiguriert ist, benachbarte Leuchtdiodencluster (2) über eine dielektrische Lücke (3b) hinweg, die nicht Teil der Schlitzstruktur (5) ist, miteinander zu verbinden,
wobei die zweite Verbindung (13) die dielektrische Lücke (3b) mit einem Übertragungskoeffizienten versieht, der niedriger als ein vorgegebener Schwellenwert für Hochfrequenzsignale bei Millimeterwellenfrequenzen ist.

14. Anzeigetafel (1) nach einem der vorhergehenden Ansprüche, wobei die Schlitzstruktur (5) eine Form aufweist, die einem griechischen Kreuz, einem Kruckenkreuz, einem Rechteck und einer Vielzahl miteinander verbundener Rechtecke entspricht.

15. Elektronische Vorrichtung (8), umfassend die Anzeigetafel (1) nach einem der Ansprüche 1 bis 14 und ein Antennenmodul (9), umfassend mindestens ein Antennenelement,
wobei die Anzeigetafel (1) eine Vielzahl gestapelter Schichten umfasst,
wobei eine erste Schicht (6) der Anzeigetafel (1) die Leuchtdiodencluster (2) der Anzeigetafel (1) umfasst, wobei mindestens eine der übrigen Schichten der Anzeigetafel (1) Öffnungen (11) umfasst, die für elektromagnetische Signale durchsichtig sind, wobei mindestens eine der Öffnungen der/den Schlitzstruktur(en) (5), die in der ersten Schicht (6) gebildet ist/sind, entspricht und auf dieser/diesen überlagert ist, wobei die Schlitzstruktur(en) (5) und die Öffnungen (11) über dem Antennenmodul (9) oder dem/den Antennenelement(en) überlagert ist/sind.

## Revendications

1. Panneau d'affichage (1) au moins partiellement transparent aux signaux électromagnétiques, ledit panneau d'affichage (1) comprenant
- une pluralité de groupes de diodes électroluminescentes (2), chaque paire de groupes de diodes électroluminescentes adjacents (2) étant séparée par un espace diélectrique (3a, 3b), et
- une pluralité de premiers agencements d'interconnexion (4) configurés pour interconnecter au moins deux groupes de diodes électroluminescentes adjacents (2),
lesdits premiers agencements d'interconnexion (4) et au moins deux desdits espaces (3a) étant configurés pour former au moins une structure de fente bidimensionnelle (5) comprenant une première section (5a) et une seconde section (5b),
ladite première section (5a) étant formée par un premier espace (3a) et ayant une première longueur (L1) le long d'un premier axe (A1), ladite première longueur (L1) étant au moins deux fois plus longue qu'une première longueur (L3) d'un groupe de diodes électroluminescentes (2) le long dudit premier axe (A1), et ladite seconde section (5b) étant formée par un second espace (3a) et ayant une seconde longueur (L2) le long d'un second axe (A2), ladite seconde longueur (L2) étant au moins deux fois plus longue qu'une seconde longueur (L4) dudit groupe de diodes électroluminescentes (2) le long dudit second axe (A2),
lesdits premiers agencements d'interconnexion (4) étant configurés de sorte qu'au moins une structure de fente (5) est transparente aux signaux électromagnétiques dans une bande de fréquences d'ondes millimétriques.

2. Panneau d'affichage (1) selon la revendication 1, comprenant une pluralité de premiers agencements d'interconnexion (4) répétés périodiquement le long dudit premier axe (A1) et dudit second axe (A2) de sorte que ledit panneau d'affichage (1) comprend une pluralité de structures de fentes (5) répétées périodiquement, des structures de fentes adjacentes (5) étant séparées par au moins un groupe de diodes électroluminescentes (2) et au moins un espace (3b) qui est configuré pour être non transparent ou transparent uniquement aux signaux électromagnétiques en dehors de la bande de fréquence d'ondes millimétriques.

3. Panneau d'affichage (1) selon la revendication 1 ou 2, dans lequel lesdits groupes de diodes électroluminescentes (2) et lesdits premiers agencements d'interconnexion (4) sont disposés dans une couche conductrice (6) dudit panneau d'affichage (1), chaque groupe de diodes électroluminescentes (2) comprenant une pluralité d'éléments électroluminescents (7).

4. Panneau d'affichage (1) selon l'une quelconque des revendications précédentes, dans lequel ladite structure de fente (5) a un coefficient de transmission qui est supérieur à un seuil prédéterminé pour les signaux radiofréquence à des fréquences d'ondes millimétriques.

5. Panneau d'affichage (1) selon l'une quelconque des revendications précédentes, dans lequel ladite pluralité de groupes de diodes électroluminescentes (2) sont disposés dans une matrice, deux rangées adjacentes de groupes de diodes électroluminescentes (2) étant séparées par ladite première section (5a) de ladite structure de fente (5), deux colonnes adjacentes de groupes de diodes électroluminescentes (2) étant séparées par ladite seconde section (5b) de ladite structure de fente (5).

6. Panneau d'affichage (1) selon la revendication 5, dans lequel ladite pluralité de groupes de diodes électroluminescentes (2) sont complètement alignés le long dudit premier axe (A1) et le long dudit second axe (A2).

7. Panneau d'affichage (1) selon la revendication 5 ou 6, dans lequel ladite pluralité de groupes de diodes électroluminescentes (2) sont partiellement désalignés le long dudit premier axe (A1) et le long dudit second axe (A2), de sorte qu'au moins un groupe de diodes électroluminescentes (2) d'une rangée de groupes de diodes électroluminescentes (2) est décalé le long dudit premier axe (A1), dans la direction dudit second axe (A2) par rapport aux autres groupes de diodes électroluminescentes (2) de ladite rangée, et/ou de sorte qu'au moins un groupe de diodes électroluminescentes (2) d'une colonne de groupes de diodes électroluminescentes (2) est décalé le long dudit second axe (A2), dans la direction dudit premier axe (A1) par rapport aux autres groupes de diodes électroluminescentes (2) de ladite colonne.

8. Panneau d'affichage (1) selon la revendication 5, dans lequel ledit premier agencement d'interconnexion (4) est configuré pour se prolonger directement à proximité des bords périphériques d'au moins deux groupes de diodes électroluminescentes (2) d'une rangée de groupes de diodes électroluminescentes (2) ou directement à proximité des bords périphériques d'au moins deux groupes de diodes électroluminescentes (2) d'une colonne de groupes de diodes électroluminescentes (2).

9. Panneau d'affichage (1) selon l'une quelconque des revendications 1 à 5, dans lequel ledit premier agencement d'interconnexion (4) comprend des interconnexions constituées d'un matériau conducteur optiquement transparent.

10. Panneau d'affichage (1) selon la revendication 9, dans lequel ledit matériau conducteur optiquement transparent a une conductivité qui permet à ladite structure de fente (5) d'avoir un coefficient de transmission qui est supérieur à un seuil prédéterminé pour les signaux radiofréquence à des fréquences d'ondes millimétriques.

11. Panneau d'affichage (1) selon la revendication 9 ou 10, dans lequel ledit premier agencement d'interconnexion (4) intercon-necte des groupes de diodes électroluminescentes adjacents (2) de sorte qu'un groupe de diodes électroluminescentes (2) d'une rangée de groupes de diodes électroluminescentes (2) est interconnecté, à travers ladite première section (5a) de ladite structure de fente (5), à un groupe de diodes électroluminescentes (2) d'une rangée adjacente de groupes de diodes électroluminescentes (2), et/ou
un groupe de diodes électroluminescentes (2) d'une colonne de groupes de diodes électroluminescentes (2) est interconnecté, à travers ladite seconde section (5b) de ladite structure de fente (5), à un groupe de diodes électroluminescentes (2) d'une colonne adjacente de groupes de diodes électroluminescentes (2).

12. Panneau d'affichage (1) selon l'une quelconque des revendications 1 à 7, dans lequel ledit premier agencement d'interconnexion (4) comprend un filtre passe-bas avec une fréquence de coupure inférieure à un seuil prédéterminé pour des signaux de radiofréquence à des fréquences d'ondes millimétriques ou un filtre coupe-bande à réjection de bande configuré pour le rejet en circuit ouvert de signaux de radiofréquence à des fréquences d'ondes millimétriques.

13. Panneau d'affichage (1) selon l'une quelconque des revendications précédentes, comprenant également un second agencement d'interconnexion (13) configuré pour interconnecter des groupes de diodes électroluminescentes adjacents (2) à travers un espace diélectrique (3b) ne faisant pas partie de ladite structure de fente (5),
ladite seconde interconnexion (13) fournissant audit espace diélectrique (3b) un coefficient de transmission inférieur à un seuil prédéterminé pour des signaux radiofréquence à des fréquences d'ondes millimétriques.

14. Panneau d'affichage (1) selon l'une quelconque des revendications précédentes, dans lequel ladite structure de fente (5) a une forme correspondant à une croix grecque, une croix potencée, un rectangle, et une pluralité de rectangles interconnec-tés.

15. Appareil électronique (8) comprenant le panneau d'affichage (1) selon l'une quelconque des revendications 1 à 14, et un module d'antenne (9) comprenant au moins un élément d'antenne, ledit panneau d'affichage (1) comprenant une pluralité de couches empilées,
une première couche (6) dudit panneau d'affichage (1) comprenant les groupes de diodes électroluminescentes (2) dudit panneau d'affichage (1), au moins l'une des couches restantes dudit panneau d'affichage (1) comprenant des ouvertures (11) transparentes aux signaux électromagnétiques, au moins l'une desdites ouvertures correspondant à, et étant superposée, aux une ou plusieurs structures de fentes (5) formées dans ladite première couche (6), lesdites une ou plusieurs structures de fentes (5) et lesdites ouvertures (11) étant superposées audit module d'antenne (9) ou auxdits un ou plusieurs éléments d'antenne.
